# EUROPEAN PATENT SPECIFICATION

(11) **EP 2 793 254 B1**
(45) Date of publication and mention of the grant of the patent: **21.10.2015**
(21) Application number: 13163968.4
(22) Date of filing: 16.04.2013
(51) Int. Cl.: H01L 21/768, H01L 23/48, H01L 21/74

(54) **Semiconductor device with through-substrate via of enhanced conductivity and corresponding fabrication method**
Halbleitervorrichtung mit Durchkontaktierung mit verbesserter Leitfähigkeit und zugehöriges Herstellungsverfahren
Dispositif semi-conducteur avec connexion traversant le substrat d'une conductivité améliorée et procédé de production d'un tel dispositif

(43) Date of publication of application: 22.10.2014
(73) Proprietor: AMS AG, 8141 Unterpremstätten (AT)
(72) Inventor: Kraft, Jochen, 8600 Oberaich (AT); Carniello, Sara, 8042 Graz (AT); Schrems, Martin, 8063 Eggersdorf (AT)
(74) Representative: Epping - Hermann - Fischer

(56) References cited:
- US-A1- 2009 174 080
- US-A1- 2010 130 002
- US-A1- 2010 308 435
- US-A1- 2011 079 920
- US-B1- 8 153 520

## Description

Through-substrate vias provide electric interconnects through a semiconductor layer forming a substrate of a semiconductor device.

WO 2012/031845 A1 discloses a through-substrate via provided with a tungsten layer, which forms the electrically conductive track of the via.

US 2010/0130002 A1 discloses a multilayered through substrate via with a sidewall coated with a titanium layer, on which TiN layers and W layers are alternatingly applied. The inner volumn of the via may be filled with a spin-on oxide.

US 2010/0308435 A1 discloses a through silicon via with embedded decoupling capacitor, which comprises a first insulator layer, a first conductor layer, a second insulator layer, a second conductor layer and a contact pad. The second insulator layer may be open at the bottom to provide an electrical connection between the first conductor layer and the second conductor layer.

US 2011/0079920 A1 discloses an electrical connection via for the substrate of a semiconductor device, which comprises a layer sequence of alternating insulating and conducting layers connecting a pad. The conducting layers are connected to one another in a region above the pad.

A through-substrate via with a width of 80 µm and a depth of 200 µm comprising a tungsten layer as electric conductor typically has a resistance of about 400 mΩ if the thickness of the tungsten layer is 200 nm. In this case the maximum current capability is typically limited to 80 mA. Much higher currents are needed for many applications of semiconductor devices. The resistance of the through-substrate via may be reduced by applying a thicker metal layer or by completely filling the via with electrically conductive material.

In the paper of K. Lee et al., "Impact of Cu Diffusion from Cu Through-Silicon Via (TSV) on Device Reliability in 3-D LSIs Evaluated by Transient Capacitance Measurement," IRPS 2012, pp. 2B.4.1 to 2B.4.6, problems arising from the contamination of a copper filling of a through-substrate via are discussed.

The deposition of a thick metal layer on a wafer surface may generate stress that makes the wafer warp. Increasing the thickness of the metal layer also increases the wafer bow, which must stay below about 100 µm to avoid wafer breakage due to robot handling in typical semiconductor processing tools. Consequently, the thickness of a tungsten layer provided as conductor in the through-substrate via must be kept smaller than about 0,8 µm. This limits the electric conductivity to less than 12/Ω, and the minimal resistance is about 83 mΩ, which is much more than desired.

The wafer bow generated by the deposition of a thick metal layer can be reduced by an etching process, as discussed in the paper of D. H. Triyoso et al., "Progress and challenges of tungsten-filled through-silicon via", IEEE International Conference on Integrated Circuit Design and Technology, ICICDT 2010, pp. 118 to 121.

For a tungsten layer that is deposited 0,8 µm thick, it has been found that the wafer bow can be reduced from about 90 µm to about 10 µm by a partial removal of the tungsten layer in a subsequent etching step.

US 2010/0240214 A1 discloses multi-layer metal structures and a manufacturing process wherein extra process steps of wafer cleaning are skipped in order to obviate problems deriving from stress between two different metal layers that are applied on a planar surface.

US 2009/0174080 A1 discloses a semiconductor device with conductive grooves. A layer sequence comprising a titanium film, a titanium nitride film and tungsten films is deposited in the grooves. Problems of exfoliation and micro-cracks of the tungsten film and warpage and cracking of the wafer are to be avoided by the repeated deposition and etch back of several thin tungsten films.

US 8,153,520 B1 discloses a method of processing partially manufactured semiconductor substrates by partially removing a tungsten layer after filling of a through silicon via to reduce substrate warpage.

It is an object of the present invention to disclose a semiconductor device comprising a through-substrate via of enhanced electric conductivity. It is a further object to disclose a method of producing such a semiconductor device.

These objects are achieved with the semiconductor device according to claim 1 and with the method of producing a semiconductor device according to claim 4. Embodiments and variants derive from the dependent claims.

The semiconductor device comprises a substrate with an upper surface, the substrate including a semiconductor layer, a connection pad below the semiconductor layer opposite the upper surface, a via opening with a sidewall in the semiconductor layer above the connection pad, and an electrically conductive via layer arranged at the sidewall and in contact with the connection pad. An electrically conductive upper via layer is arranged at the sidewall on or above the via layer and is electrically conductively connected to the connection pad.

The semiconductor device further comprises an interlayer between the via layer and the upper via layer, the interlayer comprising a material that is different from the via layer and from the upper via layer.

In an embodiment the via layer and the upper via layer comprise tensile stress and the interlayer comprises compressive stress. Thus the net mechanical stress generated by the layers is reduced, because the stress occurring in the via layers and the stress occurring in the interlayer compensate each other.

In a further embodiment the via layer and the upper via layer comprise compressive stress and the interlayer comprises tensile stress.

The interlayer is a dielectric layer, which is recessed in an area above the connection pad.

The semiconductor device further comprises an electrically conductive connection liner. The upper via layer is recessed in the area above the connection pad, and the connection liner electrically connects the upper via layer with the via layer and hence with the connection pad.

The method of producing a semiconductor device with through-substrate via comprises the steps of providing a substrate having an upper surface, the substrate including a semiconductor layer, arranging a connection pad below the semiconductor layer opposite the upper surface, producing a via opening with a sidewall in the semiconductor layer above the connection pad, and arranging an electrically conductive via layer on the upper surface, at the sidewall and in contact with the connection pad. The via layer is removed from the upper surface, and an electrically conductive further via layer is arranged on the upper surface and at the sidewall on or above the via layer and is electrically conductively connected to the via layer.

A dielectric interlayer is arranged on the via layer before the further via layer is applied, the dielectric interlayer is removed from an area above the connection pad, and the further via layer is subsequently applied. The further via layer is removed from the area above the connection pad. An electrically conductive connection liner is applied, which electrically connects the further via layer with the via layer.

The following is a detailed description of examples of the semiconductor device and of the method in conjunction with the appended figures.
- Figure 1: is a cross section of a semiconductor device.
- Figure 2: is a cross section of a further semiconductor device.
- Figure 3: is a detail of Figure 2 showing the layer sequence of the through-substrate via.
- Figure 4: is a detail according to Figure 3 for a semiconductor device comprising conductive interlayers.
- Figure 5: is a detail according to Figure 3 for a semiconductor device comprising a dielectric interlayer.
- Figure 6: is a detail according to Figure 5 for an embodiment comprising a dielectric interlayer.
- Figure 7: is a cross section of an intermediate product of an example of the method.
- Figure 8: is a cross section according to Figure 7 after the application of a further via layer.
- Figure 9: is a cross section according to Figure 8 after the application of an upper via layer.
- Figure 10: is a cross section according to Figure 9 after the application of a mask.
- Figure 11: is a cross section according to Figure 10 after the structuring of a top metal.
- Figure 12: is a cross section according to Figure 10 for a further example.

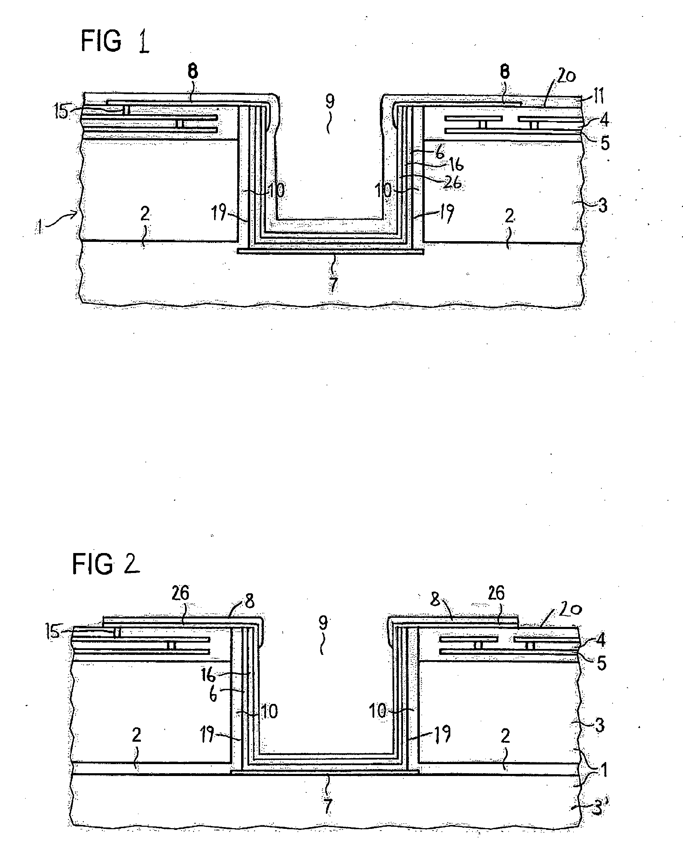

Figure 1 is a cross section of a semiconductor device comprising a substrate 1 having an upper surface 20. The substrate 1 comprises a semiconductor layer 3, which may be a silicon wafer or part of a silicon wafer, for instance. The substrate 1 may also include an intermetal dielectric 4, in which structured metallization planes 5 of a wiring are embedded. The intermetal dielectric 4 can be arranged on or above the semiconductor layer 3 and forms the upper surface 20. A further dielectric layer 2 can be arranged on the side of the semiconductor layer 3 opposite to the upper surface 20. A connection pad 7 is arranged below the semiconductor layer 3 and may preferably be embedded in the dielectric layer 2. A via opening 9 with a sidewall 19 is formed in the semiconductor layer 3 to provide a through-substrate via.

The electric conductor of the through-substrate via is formed by a sequence of electrically conductive via layers, whose number is at least two and may be three or more. In the semiconductor device according to Figure 1, the electrically conductive via layers comprise a via layer 6, a further via layer 16 and an upper via layer 26. Interlayers may be provided between the via layers, which is described below. The via layer 6 is preferably insulated from the semiconductor material of the semiconductor layer 3. This insulation may be provided by a dielectric layer 10 arranged at the sidewall 19 of the via opening 9. In semiconductor devices in which the via layers 6, 16, 26 do not extend onto the upper surface 20, as in the semiconductor device according to Figure 1, a top metal 8 may be provided to connect the via layers 6, 16, 26 with further conductors that are arranged in the region of the upper surface 20. The further conductors may include the wiring, in particular a vertical connection plug 15 of the wiring, which is shown in Figure 1 by way of example. A passivation layer 11 may be applied to cover and protect the top metal 8 and the upper surface 20.

Figure 2 is a cross section of a further semiconductor device. Elements of the further semiconductor device according to Figure 2 that correspond to elements of the semiconductor device according to Figure 1 are designated with the same reference numerals. In the semiconductor device according to Figure 2, the substrate 1 is structured like an SOI substrate (silicon on insulator substrate). The dielectric layer 2 is arranged in the substrate 1 between a semiconductor body 3' and the semiconductor layer 3. In the semiconductor device according to Figure 2, a portion of the upper via layer 26 is present on the upper surface 20 and may be structured according to the top metal 8. The top metal 8 is optional and is not necessary if the resistance of the upper via layer 26 is sufficiently low. As the upper via layer 26 is sufficiently thin, the portion of the upper via layer 26 remaining on the upper surface 20 does not generate a stress bending the substrate 1 more than tolerably. The sequence of via layers 6, 16, 26 arranged within the via opening 9 renders the resistance of the through-substrate via sufficiently low. The number of electrically conductive via layers 6, 16, 26 may be as shown in Figure 2 or may be different from three.

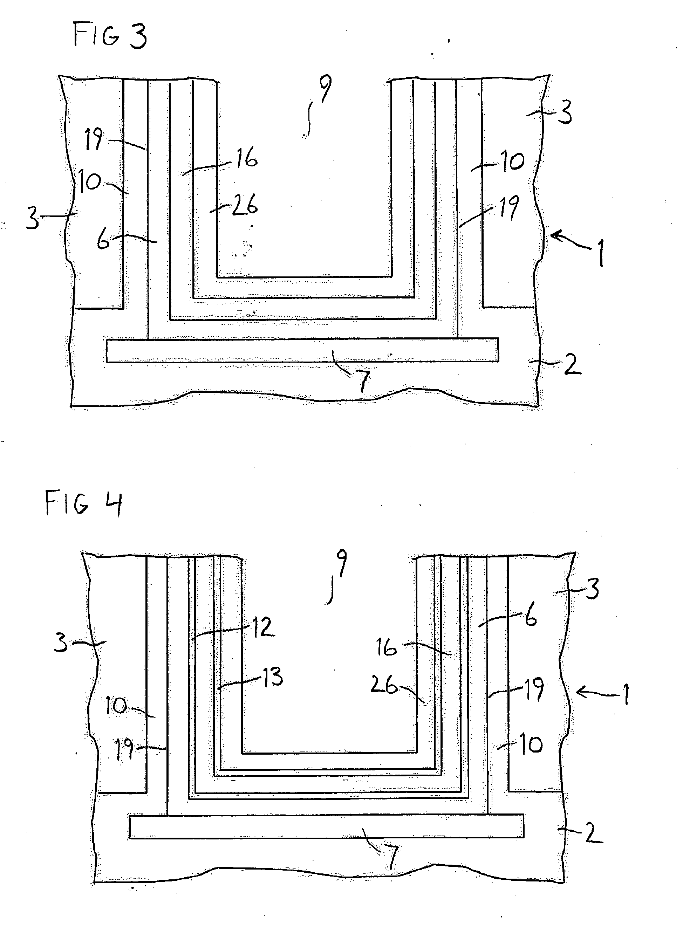

Figure 3 is a detail of Figure 2 showing the layer sequence of the through-substrate via including the basic via layer 6, a further via layer 16 and a third via layer, which is the upper via layer 26. The number of electrically conductive via layers 6, 16, 26, which is three in the semiconductor device shown in Figure 3, is at least two and may be larger than three. The sidewall 19 of the via opening 9 is formed by the dielectric layer 10 insulating the via layer 6 from the semiconductor layer 3. The electrically conductive via layer 6 is in electric contact with the connection pad 7. The via layers 6, 16, 26 may comprise any electrically conductive material used in semiconductor technology like tungsten, copper, aluminum, electrically conductively doped polysilicon or combinations thereof, for instance. The via layers 6, 16, 26 may comprise different electrically conductive materials or may instead all be formed from the same material.

Figure 4 is a detail according to Figure 3 for a semiconductor device comprising electrically conductive interlayers 12, 13 between the electrically conductive via layers 6, 16, 26. The number of via layers 6, 16, 26 may differ from three. A first interlayer 12, which may be a liner formed from TiN or TaN, for instance, is arranged between the via layer 6 and the further via layer 16. A second interlayer 13, which may also be a liner of TiN or TaN, for instance, is arranged between the further via layer 16 and the upper via layer 26. If there is another number of via layers, the number of interlayers may differ accordingly. Interlayers may be provided between each pair of subsequent via layers or may only be provided between some of the via layers. The interlayers 12, 13 may be provided as buffer layers, in particular for a reduction or compensation of stress that may occur between the via layers 6, 16, 26. As the interlayers 12, 13 are electrically conductive in the semiconductor device according to Figure 4, the electric conductivity of the through-substrate via is not essentially affected by the presence of the interlayers 12, 13.

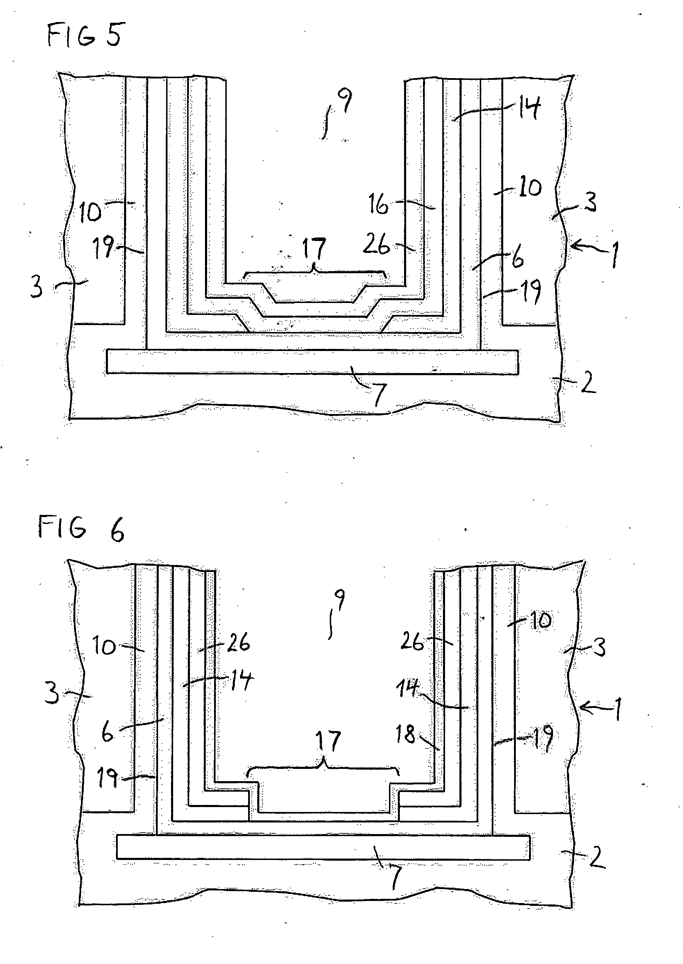

Figure 5 is a detail according to Figure 3 for a semiconductor device comprising a dielectric interlayer 14 between the via layer 6 and the further via layer 16. The number of electrically conductive via layers 6, 16, 26, which is three in the semiconductor device shown in Figure 5, is at least two and may be larger than three. The dielectric interlayer 14 may be SiO₂, for instance. The dielectric interlayer 14 is recessed in an area 17 above the connection pad 7. In this area 17 the further via layer 16 is directly applied on the via layer 6, so that the via layer 6 and the further via layer 16 are electrically conductively connected to one another. A further recessed dielectric interlayer, which is not shown in Figure 5, may be arranged between the further via layer 16 and the upper via layer 26. Dielectric interlayers 14 may be provided between each pair of subsequent via layers or may only be provided between a selected number of via layers. The dielectric interlayers 14 may be provided as buffer layers to reduce stress that may occur between the via layers 6, 16, 26. Recesses of the dielectric interlayers 14 in the area 17 above the connection pad 7 allow the via layers 6, 16, 26 to be electrically conductively connected to one another. In further semiconductor devices, dielectric interlayers 14 and electrically conductive interlayers 12, 13 as used in the semiconductor device according to Figure 4 may be combined or alternatively applied between the via layers 6, 16, 26.

Figure 6 is a detail according to Figure 5 for an embodiment comprising a dielectric interlayer 14. In the embodiment according to Figure 6 there are only two via layers: the basic via layer 6 and the upper via layer 26, which is recessed in the area 17 above the connection pad 7. There may be further via layers as in the semiconductor devices described above. An electrically conductive connection between the upper via layer 26 and the via layer 6 is provided by an electrically conductive connection liner 18, which may be TiN or TaN, for instance. If there are further electrically conductive via layers besides the two via layers 6, 26 shown in Figure 6, each further via layer 16 may be recessed in the area 17 above the connection pad 7 to allow an electric connection of all the via layers 6, 16, 26 by means of the connection liner 18. Dielectric interlayers 14 may be provided between each pair of subsequent via layers or may instead only be provided between a selected number of via layers. Dielectric interlayers 14 and electrically conductive interlayers 12, 13 as used in the semiconductor device according to Figure 4 may be combined or alternatively applied in an embodiment in which the via layers are connected by means of a connection liner 18.

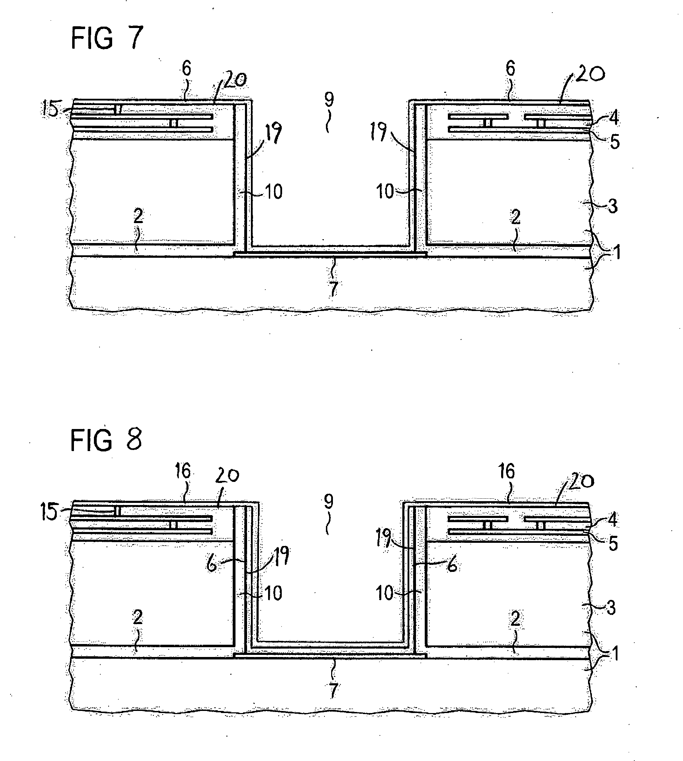

Figure 7 is a cross section of an intermediate product of an example of the method of producing a semiconductor device with through-substrate via. Elements of the intermediate product according to Figure 7 that correspond to elements of the semiconductor device according to Figure 1 are designated with the same reference numerals. Figure 7 shows the via layer 6 applied on the upper surface 20, at the sidewall 19 of the via opening 9 and on the connection pad 7.

Figure 8 is a cross section according to Figure 7 after the removal of the via layer 6 from the upper surface 20 and the application of a further via layer 16, which is applied on the upper surface 20, at the sidewall 19 on the remaining portion of the via layer 6, and above the connection pad 7. An interlayer 12, 14 as described above may be applied on the via layer 6 before the further via layer 16 is applied. If a dielectric interlayer 14 is applied, it is removed in an area 17 above the connection pad 7. This may be performed by a spacer etch, which is generally anisotropic but, owing to the large aspect ratio of the relatively deep via opening 9, yields the recessed structure of the dielectric interlayer 14 shown in Figures 5 and 6 with a peripheral portion of the dielectric interlayer 14 remaining above the connection pad 7. As the via layer 6 had been removed from the upper surface 20, the conductor layer that is now present on the upper surface 20 is formed by the further via layer 16 only, which is sufficiently thin to prevent an undesired wafer bow. The further via layer 16 is then also removed from the upper surface 20. If an interlayer 12, 14 had been provided, it is also removed from the upper surface 20 in this step.

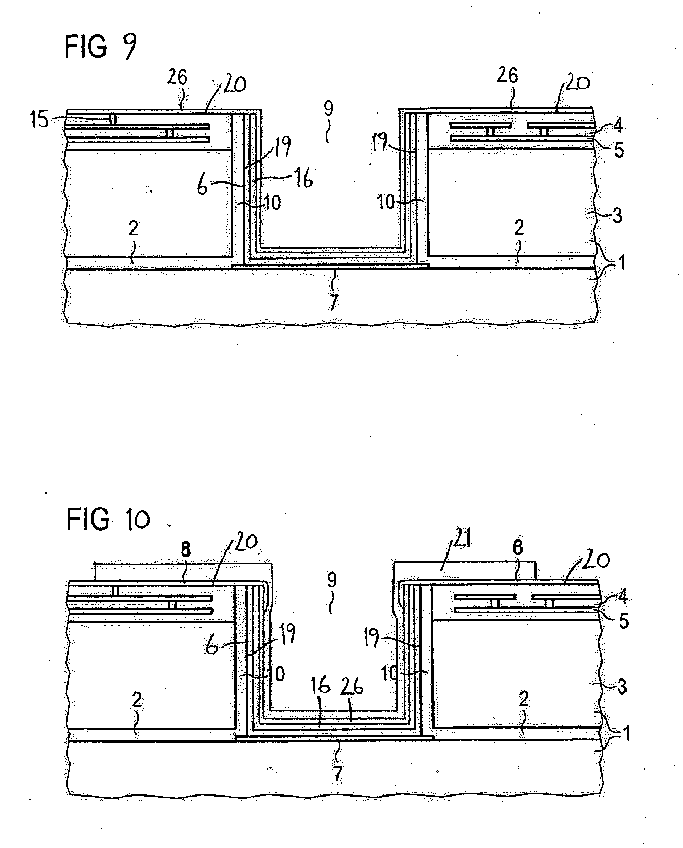

Figure 9 is a cross section according to Figure 8 after the application of an upper via layer 26 on the upper surface 20, at the sidewall 19 on the remaining portions of the via layer 6 and the further via layer 16 and above the connection pad 7. An interlayer 13, 14 as described above may be applied on the further via layer 16 before the upper via layer 26 is applied. If a further dielectric interlayer 14 is applied, it is removed in an area 17 above the connection pad 7. This may be performed by a spacer etch as described above. The upper via layer 26, together with an interlayer 12, 14, if provided, may then be removed from the upper surface 20.

By the described method a sequence of any number of electrically conductive via layers and interlayers provided as buffer or stress compensation layers can be produced to obtain the desired good electric conductivity of the through-substrate via. At the same time the risk of a strong wafer bow is effectively avoided, because the upper surface 20 is not covered by more than one of the applied via layers during the manufacturing process. After all via layers have been applied, the upper via layer 26 may be left on the upper surface 20, or it may be removed together with an uppermost interlayer 12, 14, if provided, from the upper surface 20.

Figure 10 is a cross section according to Figure 9 after the application of a top metal 8 and a first mask 21. In the intermediate product shown in Figure 10, the upper via layer 26 has been removed from the upper surface 20 before the top metal 8 has been applied. The top metal 8 is structured by an etching step according to the structure of the first mask 21.

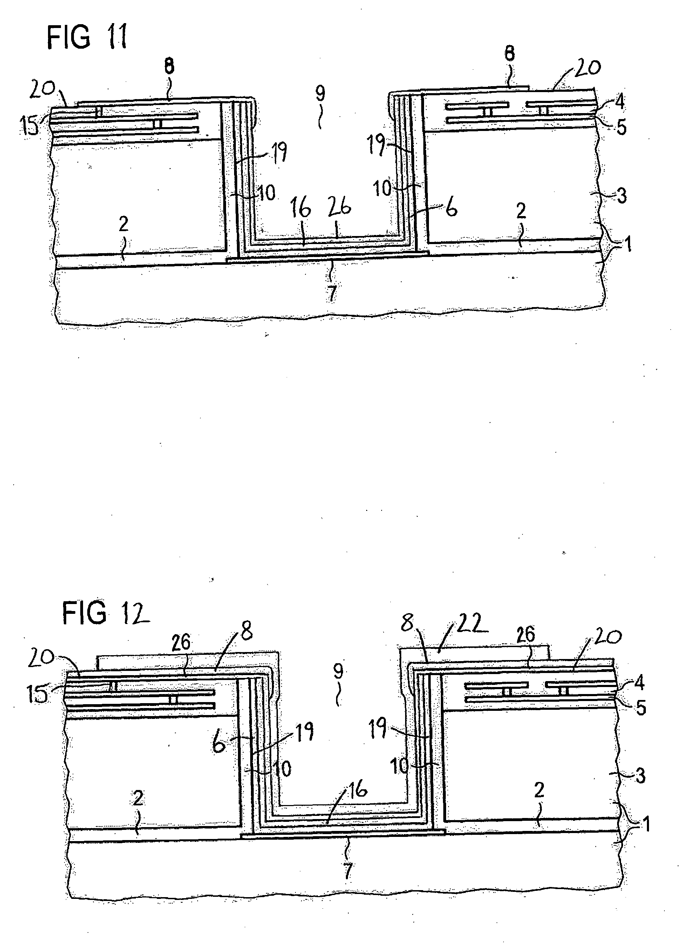

Figure 11 is a cross section according to Figure 10 after the structuring of the top metal 8. In the state shown in Figure 11 the first mask 21 has already been removed. A passivation layer 11 may be applied on top to render the device according to Figure 1. The remaining portion of the structured top metal 8 connects the via layers 6, 16, 26 with a plug 15 of the wiring and/or with other conductors of the semiconductor device. In this way the connection pad 7 is electrically connected with a conductor at or near the upper surface 20. The connection pad 7 may be connected with external terminals or with conductors that are arranged at the rear side of the substrate 1. These details are not essential to the invention and hence not shown in the Figures.

Figure 12 is a cross section according to Figure 10 for a further example. Elements of the further example according to Figure 12 that correspond to elements of the intermediate product according to Figure 10 are designated with the same reference numerals. In the example according to Figure 12 the upper via layer 26 has been left on the upper surface 20, and the top metal 8 has been applied on the upper portion of the upper via layer 26. The top metal 8 is structured by an etching step together with the upper portion of the upper via layer 26 according to the structure of a second mask 22. The result of this method step after the removal of the second mask 22 is shown in Figure 2. The remaining portion of the structured top metal 8 connects the via layers 6, 16, 26 with a plug 15 of the wiring and/or with other conductors of the semiconductor device. In this way the connection pad 7, which may be connected with external terminals or with conductors that are arranged at the rear side of the substrate 1, is electrically connected with a conductor at or near the upper surface 20. In the semiconductor device according to Figure 2, the top metal 8 is optional, and the portion of the upper via layer 26 remaining on the upper surface 20 may suffice as an electric conductor without the top metal 8 being applied.

The described formation of stress-buffered multiple conductive layers for through-substrate vias comprises subsequent etching steps to remove the succeeding conductive layers from the planar substrate surface while leaving the sidewall and the bottom of the open via unetched. Particle collisions in which ions at the bottom of the via opening lose energy are augmented by increasing the pressure during an RIE step (reactive ion etching). This results in the main etch attack being directed to the upper substrate surface. This can be achieved with any electrically conductive layers, including tungsten, copper or doped polysilicon layers, for instance.

The described method, in which the sequence of via layers is produced with intervening etchback steps, solves the problem of keeping the layer stress on the upper surface within tolerable limits while allowing the electric conductivity of the through-substrate via to be optimized. The insertion of electrically conductive buffer layers, which compensate the stress occurring between the via layers, allows a common structuring of all the via layers by one masked etching step. The insertion of dielectric buffer layers is an alternative that is easily feasible, because the dielectric buffer layers can be structured according to a well-known spacer etching, which allows the conductive via layers to be etched back independently outside the via opening.

### List of reference numerals

- 1: substrate
- 2: dielectric layer
- 3: semiconductor layer
- 3': semiconductor body
- 4: intermetal dielectric
- 5: metallization plane
- 6: via layer
- 7: connection pad
- 8: top metal
- 9: via opening
- 10: dielectric layer
- 11: passivation layer
- 12: first interlayer
- 13: second interlayer
- 14: dielectric interlayer
- 15: plug
- 16: further via layer
- 17: area above the connection pad
- 18: connection liner
- 19: sidewall
- 20: upper surface
- 21: first mask
- 22: second mask
- 26: upper via layer

## Claims

1. A semiconductor device with a through-substrate via, comprising:
- a substrate (1) with an upper surface (20), the substrate (1) including a semiconductor layer (3),
- a connection pad (7) below the semiconductor layer (3) opposite the upper surface (20),
- a via opening (9) with a sidewall (19) in the semiconductor layer (3) above the connection pad (7),
- an electrically conductive via layer (6) arranged at the sidewall (19) and in contact with the connection pad (7),
- an electrically conductive upper via layer (26) arranged at the sidewall (19) above the via layer (6) and electrically conductively connected to the connection pad (7),
- an interlayer (14) between the via layer (6) and the upper via layer (26), the interlayer (14) comprising a material that is different from the via layer (6) and from the upper via layer (26).
- the interlayer (14) being a dielectric layer,
- the interlayer (14) being recessed in an area (17) above the connection pad (7),
- an electrically conductive connection liner (18),
- the upper via layer (26) being recessed in the area (17) above the connection pad (7), and
- the connection liner (18) electrically connecting the upper via layer (26) with the via layer (6).

2. The semiconductor device of claim 1, wherein
the via layer (6) and the upper via layer (26) comprise tensile stress and the interlayer (12, 13, 14) comprises compressive stress.

3. The semiconductor device of claim 1, wherein
the via layer (6) and the upper via layer (26) comprise compressive stress and the interlayer (12, 13, 14) comprises tensile stress.

4. A method of producing a semiconductor device with through-substrate via, comprising:
- providing a substrate (1) having an upper surface (20), the substrate (1) including a semiconductor layer (3),
- arranging a connection pad (7) below the semiconductor layer (3) opposite the upper surface (20),
- producing a via opening (9) with a sidewall (19) in the semiconductor layer (3) above the connection pad (7), and
- arranging an electrically conductive via layer (6) on the upper surface (20), at the sidewall (19) and in contact with the connection pad (7),
- removing the via layer (6) from the upper surface (20),
- arranging a dielectric interlayer (14) on the via layer (6),
- removing the dielectric interlayer (14) from an area (17) above the connection pad (7),
- subsequently applying an electrically conductive further via layer (16) on the upper surface (20) and at the sidewall (19) above the via layer (6), the further via layer (16) being electrically conductively connected to the via layer (6),
- the further via layer (16) being removed from the area (17) above the connection pad (7), and
- an electrically conductive connection liner (18) being applied electrically connecting the further via layer (16) with the via layer (6).

## Patentansprüche

1. Halbleiterbauteil mit einer Substratdurchkontaktierung, Folgendes aufweisend:
- ein Substrat (1) mit einer Oberseite (20), wobei das Substrat (1) eine Halbleiterschicht (3) aufweist,
- einen der Oberseite (20) entgegengesetzten Anschlusskontaktfleck (7) unter der Halbleiterschicht (3),
- eine Durchkontaktierungsöffnung (9) mit einer Seitenwand (19) in der Halbleiterschicht (3) über dem Anschlusskontaktfleck (7),
- eine elektrisch leitfähige Durchkontaktierungsschicht (6), die an der Seitenwand (19) angeordnet und in Kontakt mit dem Anschlusskontaktfleck (7) ist,
- eine elektrisch leitfähige, obere Durchkontaktierungsschicht (26), die an der Seitenwand (19) über der Durchkontaktierungsschicht (6) angeordnet und elektrisch leitfähig an den Anschlusskontaktfleck (7) angeschlossen ist,
- eine Zwischenschicht (14) zwischen der Durchkontaktierungs¬schicht (6) und der oberen Durchkontaktierungsschicht (26), wobei die Zwischenschicht (14) ein Material umfasst, das sich von der Durchkontaktierungsschicht (6) und von der oberen Durchkontaktierungsschicht (26) unterscheidet,
- wobei es sich bei der Zwischenschicht (14) um eine dielektrische Schicht handelt,
- wobei die Zwischenschicht (14) in einer Zone (17) über dem Anschlusskontaktfleck (7) vertieft ist,
- eine elektrisch leitfähige Anschlusseinlage (18),
- wobei die obere Durchkontaktierungsschicht (26) in der Zone (17) über dem Anschlusskontaktfleck (7) vertieft ist, und
- wobei die Anschlusseinlage (18) die obere Durchkontaktie¬rungs¬schicht (26) elektrisch mit der Durchkontaktierungs¬schicht (6) verbindet.

2. Halbleiterbauteil nach Anspruch 1, wobei die Durchkontaktierungsschicht (6) und die obere Durchkontaktierungsschicht (26) eine Zugspannung haben, und die Zwischenschicht (12, 13, 14) eine Druckspannung hat.

3. Halbleiterbauteil nach Anspruch 1, wobei die Durchkontaktierungsschicht (6) und die obere Durchkontaktierungsschicht (26) eine Druckspannung haben, und die Zwischenschicht (12, 13, 14) eine Zugspannung hat.

4. Verfahren zum Herstellen eines Halbleiterbauteils mit einer Substratdurchkontaktierung, Folgendes umfassend:
- Bereitstellen eines Substrats (1) mit einer Oberseite (20), wobei das Substrat (1) eine Halbleiterschicht (3) aufweist,
- Anordnen eines Anschlusskontaktflecks (7) der Oberseite (20) entgegengesetzt unter der Halbleiterschicht (3),
- Herstellen einer Durchkontaktierungsöffnung (9) mit einer Seitenwand (19) in der Halbleiterschicht (3) über dem Anschlusskontaktfleck (7), und
- Anordnen einer elektrisch leitfähigen Durchkontaktierungs¬schicht (6) auf der Oberseite (20) an der Seitenwand (19) und in Kontakt mit dem Anschlusskontaktfleck (7),
- Entfernen der Durchkontaktierungsschicht (6) von der Oberseite (20),
- Anordnen einer dielektrischen Zwischenschicht (14) auf der Durchkontaktierungsschicht (6),
- Entfernen der dielektrischen Zwischenschicht (14) aus einer Zone (17) über dem Anschlusskontaktfleck (7),
- anschließend Aufbringen einer elektrisch leitfähigen weiteren Durchkontaktierungsschicht (16) auf die Oberseite (20) und an der Seitenwand (19) über der Durchkontaktierungs¬schicht (6), wobei die weitere Durchkontaktierungsschicht (16) elektrisch leitfähig an die Durchkontaktierungsschicht (6) angeschlossen wird,
- wobei die weitere Durchkontaktierungsschicht (16) aus der Zone (17) über dem Anschlusskontaktfleck (7) entfernt wird, und
- wobei eine elektrisch leitfähige Anschlusseinlage (18) aufgebracht wird, welche die weitere Durchkontaktierungsschicht (16) elektrisch mit der Durchkontaktierungsschicht (6) verbindet.

## Revendications

1. Dispositif semi-conducteur présentant une interconnexion traversant le substrat, comprenant:
- un substrat (1) présentant une surface supérieure (20), le substrat (1) incluant une couche semi-conductrice (3),
- une pastille de connexion (7) sous la couche semi-conductrice (3) à l'opposé de la surface supérieure (20),
- un orifice d'interconnexion (9) présentant une paroi latérale (19) dans la couche semi-conductrice (3) au-dessus de la pastille de connexion (7),
- une couche d'interconnexion électriquement conductrice (6) agencée au niveau de la paroi latérale (19) et en contact avec la pastille de connexion (7),
- une couche d'interconnexion supérieure électriquement conductrice (26) agencée au niveau de la paroi latérale (19) au-dessus de la couche d'interconnexion (6) et connectée de manière électriquement conductrice à la pastille de connexion (7),
- une couche intermédiaire (14) entre la couche d'interconnexion (6) et la couche d'interconnexion supérieure (26), la couche intermédiaire (14) comprenant un matériau qui est différent de la couche d'interconnexion (6) et de la couche d'interconnexion supérieure (26),
- la couche intermédiaire (14) étant une couche diélectrique,
- la couche intermédiaire (14) étant évidée dans une zone (17) au-dessus de la pastille de connexion (7),
- un revêtement de connexion électriquement conducteur (18),
- la couche d'interconnexion supérieure (26) étant évidée dans la zone (17) au-dessus de la pastille de connexion (7), et
- le revêtement de connexion (18) connectant électriquement la couche d'interconnexion supérieure (26) à la couche d'interconnexion (6).

2. Le dispositif semi-conducteur de la revendication 1, dans lequel
la couche d'interconnexion (6) et la couche d'interconnexion supérieure (26) comportent un effort de traction et la couche intermédiaire (12, 13, 14) comporte un effort de compression.

3. Le dispositif semi-conducteur de la revendication 1, dans lequel
la couche d'interconnexion (6) et la couche d'interconnexion supérieure (26) comportent un effort de compression et la couche intermédiaire (12, 13, 14) comporte un effort de traction.

4. Procédé de production d'un dispositif semi-conducteur présentant une interconnexion traversant le substrat, comprenant:
- la fourniture d'un substrat (1) présentant une surface supérieure (20), le substrat (1) incluant une couche semi-conductrice (3),
- l'agencement d'une pastille de connexion (7) sous la couche semi-conductrice (3) à l'opposé de la surface supérieure (20),
- la production d'un orifice d'interconnexion (9) présentant une paroi latérale (19) dans la couche semi-conductrice (3) au-dessus de la pastille de connexion (7), et
- l'agencement d'une couche d'interconnexion électriquement conductrice (6) sur la surface supérieure (20), au niveau de la paroi latérale (19) et en contact avec la pastille de connexion (7),
- le fait d'enlever la couche d'interconnexion (6) de la surface supérieure (20),
- l'agencement d'une couche intermédiaire diélectrique (14) sur la couche d'interconnexion (6),
- le fait d'enlever la couche intermédiaire diélectrique (14) d'une zone (17) au-dessus de la pastille de connexion (7),
- l'application subséquente d'une couche d'interconnexion électriquement conductrice supplémentaire (16) sur la surface supérieure (20) et au niveau de la paroi latérale (19) au-dessus de la couche d'interconnexion (6), la couche d'interconnexion supplémentaire (16) étant connectée de manière électriquement conductrice à la couche d'interconnexion (6),
- la couche d'interconnexion supplémentaire (16) étant enlevée de la zone (17) au-dessus de la pastille de connexion (7), et
- un revêtement de connexion électriquement conducteur (18) étant appliqué de manière à connecter électriquement la couche d'interconnexion supplémentaire (16) à la couche d'interconnexion (6).
